(19) Europäisches Patentamt

European Patent Office

Office européen des brevets

(11) **EP 0 884 600 B1**

(12) **EUROPÄISCHE PATENTSCHRIFT**

(45) Veröffentlichungstag und Bekanntmachung des Hinweises auf die Patenterteilung:
**30.07.2003   Patentblatt 2003/31**

(51) Int Cl.$^7$: **G01R 31/36**

(21) Anmeldenummer: **98108574.9**

(22) Anmeldetag: **12.05.1998**

(54) **Vorrichtung und Verfahren zur Überwachung des Ladezustands einer Batterie**

Device and method for monitoring the state of charge of a battery

Dispositif et procédé de surveillance de l'état de charge d'une batterie

(84) Benannte Vertragsstaaten:
**DE FR GB IT SE**

(30) Priorität: **14.06.1997   DE 19725204**

(43) Veröffentlichungstag der Anmeldung:
**16.12.1998   Patentblatt 1998/51**

(73) Patentinhaber: **Delphi Automotive Systems Deutschland GmbH D-42369 Wuppertal (DE)**

(72) Erfinder:
• **Klütz, Siegfried 51766 Engelskirchen (DE)**
• **Faust, Benedikt 56637 Plaidt (DE)**

(74) Vertreter: **Cohausz & Florack Patentanwälte Kanzlerstrasse 8a 40472 Düsseldorf (DE)**

(56) Entgegenhaltungen:
**DE-A- 3 536 111**          **GB-A- 2 278 452**

**Beschreibung**

Die Erfindung betrifft eine Vorrichtung und ein Verfahren zur Überwachung der Kapazität einer Batterie, insbesondere in Schlüsselsendern oder Fernbedienungen wie in automotiven Anwendungen, mit Meßmitteln für die Klemmenspannung und mit Mitteln zur Berechnung des Innenwiderstandes der Batterie sowie mit weiteren Mitteln zur Feststellung des Ladezustandes der Batterie aus den gemessenen Größen.

Eine Vorrichtung der eingangs genannten Art ist aus der DE-OS 44 18 194 bekannt. Es handelt sich um ein System zum Bestimmen der Kapazität einer aufladbaren Speicherbatterie eines Automobiles, insbesondere zur Bestimmung der Restkapazität (Ladezustand) einer solchen Batterie. Es ist aus dieser Druckschrift bekannt, daß die Batterierestkapazität eine Funktion der Elektrolytdichte ist und die Elektrolytdichte mit dem Innenwiderstand der Batterie und mit dem Entladungsstrom von der Batterie korreliert ist. Hierbei wird der Innenwiderstand der Batterie berechnet durch Erfassung der Klemmenspannung in einem unterbrochenen Zustand, bei dem die Verbindungen zu allen elektrischen Verbrauchern unterbrochen sind, und einer davon unterschiedlichen Klemmenspannung in einem selektiv verbundenen Zustand, bei dem eine Verbindung nur zu einem elektrischen Verbraucher hergestellt ist, sowie aus dem Entladungsstrom in diesem verbundenen Zustand. Die Erfassung der Batterierestkapazität erfolgt anschließend bei der aktuellen Temperaturbedingung im Zusammenhang mit einer Tabelle, die den Zusammenhang zwischen Batterierestkapazität, Entladungsstrom und Innenwiderstand darstellt.

Dieses Verfahren ist aufwendig, weil hierzu in mehreren Schritten Berechnungen durchgeführt werden müssen und darüber hinaus das Abschalten der Batterie von allen Verbrauchern bzw. selektiv von einzelnen Verbrauchern einen erheblichen Schaltvorgang hervorruft.

Daneben ist aus der DE-PS 34 07 409 ein Prüfverfahren für Batterien bekannt, bei dem deren Innenwiderstand gemessen wird und aus dem Vergleich mit einer mit dem Prüfling typgleichen Gleichstromquelle eines festgelegten Ladezustandes der Ladezustand des Prüflings ermittelt. wird. Dieses Verfahren ist aufwendig, weil eine zweite Bezugsbatterie ständig vorgehalten werden muß.

Aus der DE-OS-38 18 034 ist ein Meßgerät bekannt, welches den Innenwiderstand von Batterien direkt anzeigt. Die Messung erfolgt über eine frequenzbandbegrenzte Verstärkerstufe durch Beaufschlagung der Batterie als Prüfobjekt mit einer Wechselstromquelle.

Schließlich zeigt die DE-OS 35 36 111 eine Schaltung zur Messung des Innenwiderstandes einer Batterie über einen parallel zur Batterie anlegbaren Testkondensator, der bis zum Erreichen einer Bezugsspannung aufgeladen wird. Aus der zur Aufladung erforderlichen Zeitspanne und der Zeitkonstante des exponentiell verlaufenden Ladevorgangs, die eine Funktion des Innenwiderstandes darstellt, läßt sich der gesuchte Innenwiderstand berechnen. Nachteilig ist bei dieser Messung, daß die Batterie während der Messung vom Verbraucher getrennt werden muß.

Andererseits sind aus der Praxis Verfahren bekannt, die Messung der Restkapazität einer Batterie durch Überwachung der Klemmenspannung an der Batterie vorzunehmen, da die Spannung einer typischen Lithium-Zelle bei einer konstanten Belastung zum Ende der Lebensdauer hin progressiv abnimmt. Findet eine Belastung einer Lithiumzelle jedoch nur gelegentlich statt, wie es beispielsweise bei einem Schlüsselsender der Fall ist, so nähert sich die Zellspannung stets wieder dem Gleichgewichtswert. In einem solchen Fall ist eine Methode zur Abschätzung der Batteriekapazität, die sich nur auf die Batteriespannung bezieht, nicht geeignet, da durch das zwischenzeitliche "Erholen" der Batterie eine voll geladenen Batterie vorgetäuscht wird.

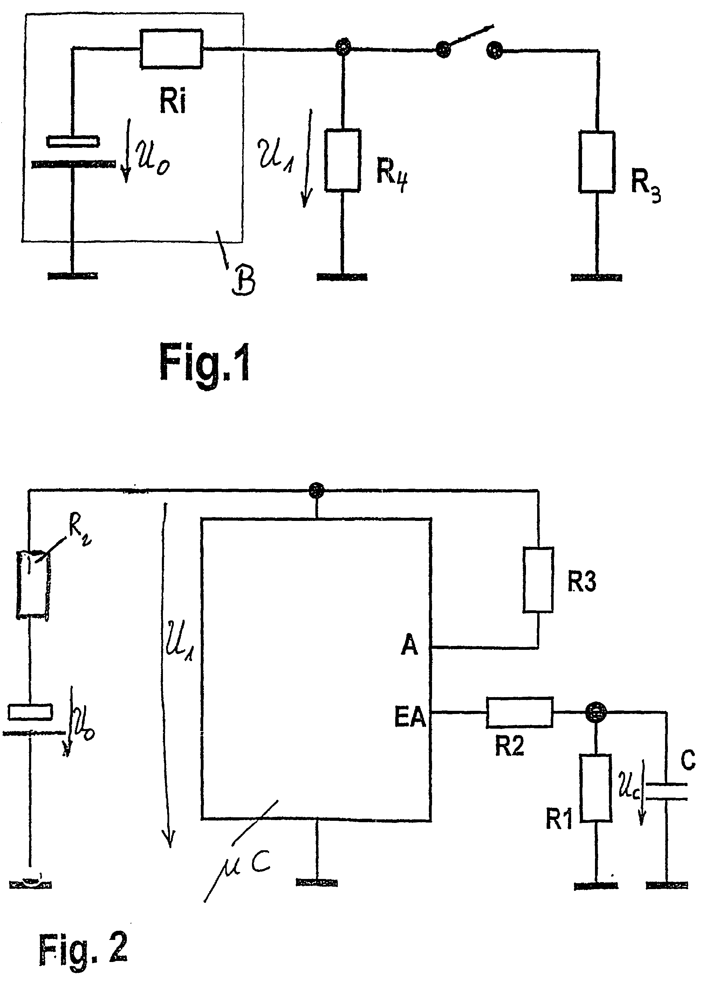

Ein weiterer Nachteil der reinen Spannungsmessung besteht in der starken Temperaturabhängigkeit des Spannungsverlaufs (Fig. 2), der durch die Nernstsche Gleichung beschrieben wird:

$$\varphi = \varphi_0 + (R^*T/z^*F)\ ^*\ln\ (MWG)$$

Hier wird das Elektrodenpotential $\varphi$ durch das entsprechende Standardelektrodenpotential $\varphi_0$ und einen weiteren Term vorgegeben, in den die absolute Temperatur T linear. eingeht. Der zum Ende der Lebensdauer beobachtete Spannungseinbruch hängt also auch von der Temperatur ab und kann somit nur bedingt zur Kapazitätsabschätzung verwendet werden.

Es ist Aufgabe der Erfindung, eine Vorrichtung bzw. ein Verfahren zu entwickeln, die es erlauben, eine zuverlässige Auskunft über die verfügbare Zellkapazität (Ladezustand) zu geben, wobei insbesondere die Kapazität auch bei nur gelegentlichen Belastungen einer Zelle korrekt bestimmt werden soll. Zudem soll eine Temperaturabhängigkeit des Meßergebnisses weitgehend vermieden werden.

Diese Aufgabe wird erfindungsgemäß durch die Merkmale des Anspruchs 1 gelöst.

Gemäß dem verfahrensmäßigen Aspekt der Erfindung wird diese Aufgabe durch die Merkmale des Anspruchs 5 gelöst.

Ein Vorteil der erfindungsgemäßen Lösung besteht darin, daß die Vorrichtung bzw. das Verfahren unabhängig davon sind, ob an der Batterie eine konstante Belastung anliegt, oder aber nur gelegentliche Belastungen stattfinden, da der Innenwiderstand (Zellwiderstand), der erfindungsgemäß bestimmt wird, unabhängig ist von der Art und Weise der erfolgten Belastung. Ein weiterer Vorteil der. Erfindung liegt in der weitgehenden Temperaturunabhängigkeit des inneren Widerstandes der Batterie. Schließlich sind durch die Bestimmung des inneren Widerstandes der Batterie unter Zuhilfenahme eines Referenzwiderstandes die Kosten niedriger, als bei einer Bestimmung des inneren Widerstandes unter Zuhilfenahme einer Referenzspannung oder eines Referenzstroms.

Nach einer bevorzugten Ausführungsform der Erfindung besteht die Lade-/Entladeschaltung bei der erfindungsgemäßen Vorrichtung aus einer Parallelschaltung eines Widerstandes und eines Kondensators, wobei die Entladung des Kondensators über diesen Widerstand erfolgt.

Eine weitere bevorzugte Ausführungsform der Erfindung sieht vor, daß der Ladevorrichtung ein weiterer Widerstand vorgeschaltet ist, mit dem der Strom beim Aufladen der Ladevorrichtung begrenzt wird.

Zur näheren Erläuterung der Erfindung wird im folgenden ein Ausführungsbeispiel anhand von Zeichnungen beschrieben. Dabei zeigen:

Fig. 1     ein Blockschaltbild zur Erläuterung des erfindungsgemäßen Prinzips,

Fig. 2     ein Blockschaltbild gemäß Ausführungsbeispiel der Erfindung, und

Fig. 3     den Spannungsverlauf Uc am Kondensator C gemäß der bevorzugten Ausführungsform in Fig. 2.

In Fig. 1 ist eine Batterie B durch ein Ersatzschaltbild aus einer idealen Spannungsquelle $U_0$ und einem in Reihe geschaltetem Innenwiderstand $R_i$ dargestellt. Außerhalb der Batterie B ist zur Kennzeichnung eines Verbrauchers ein Lastwiderstand $R_4$ mit der Batterie in Reihe geschaltet. Zusätzlich ist ein Referenzwiderstand $R_3$ über einen Schalter S1 parallel zu dem Lastwiderstand $R_4$ zu- oder abschaltbar:

Ohne Referenzwiderstand $R_3$ wird an der Batterie B die Spannung $U_1$ gemessen. Sobald der Referenzwiderstand $R_3$ zugeschaltet wird, sinkt die Spannung von $U_1$ um $\Delta U_1$ auf $U_1'$ ab. Aus der folgenden Rechnung wird deutlich, daß der prozentuale Spannungseinbruch $\Delta U_1/U_1$ der Klemmenspannung bei Belastung mit dem Referenzwiderstand $R_3$ in etwa proportional zum Innenwiderstand $R_i$ der Batterie ist, wenn vorausgesetzt wird, daß $R_3$ klein ist gegen den Lastwiderstand $R_4$:

$$U_1 = U_0 * \frac{R_4}{R_i + R_4}$$

$$U'_1 = U_0 * \frac{R_4 \| R_3}{R_i + (R_4 \| R_3)}$$

$$\Rightarrow \frac{\Delta U_1}{U_1} = R_4 * \frac{R_i}{R_4 R_3 + R_4 R_i + R_3 R_i}$$

$$\Rightarrow R_i = R_3 * \frac{\Delta U_1}{U_1} * \frac{1}{1 - \frac{\Delta U_1}{U_1} - \frac{\Delta U_1}{U_1} * \frac{R_3}{R_4}}$$

$$\Rightarrow R_i \approx R_3 * \frac{\Delta U_1}{U_1} \qquad \text{für} \quad \frac{\Delta U_1}{U_1} \ll 1,\ R3 \ll R4 \tag{1}$$

Wird $R_3$ als fester Widerstand gewählt, so genügt für die Messung des Innenwiderstands $R_i$ und damit für die Überwachung der Batteriekapazität die Bestimmung des Verhältnisses $\Delta U_1/U_1$.

Für die Bestimmung dieses Verhältnisses wird die Schaltung in Figur 2 herangezogen, die die bevorzugte Ausführungsform gemäß der Erfindung darstellt.

Figur 2 zeigt ebenfalls die Batterie B als Reihenschaltung einer idealen Spannungsquelle $U_0$ und eines Innenwiderstands $R_i$, an deren Klemmenspannung ein Mikrocontroller μ C angeschlossen ist. Weiterhin ist zwischen den Ein-/Ausgang des Mikrocontrollers EA und Erde eine Reihenschaltung eines Widerstandes $R_2$ und einer Parallelschaltung eines weiteren Widerstandes $R_1$ mit einem Kondensator C gelegt. Schließlich ist in der Schaltung ein Referenzwiderstand $R_3$ mit der Klemmenspannung ($U_1$) der Batterie B und dem Eingang A des Mikrocontrollers μC verbunden, wobei der Widerstand $R_3$ analog zur Betrachtung der Figur 1 klein gegen die Parallelschaltung des (nicht dargestellten) Lastwiderstandes $R_4$ sein muß, damit Gleichung (1) weiterhin gilt. Der Mikrocontroller μ C ist in der Lage,

sowohl den Referenzwiderstand $R_3$ als auch die Reihenschaltung von Widerstand $R_2$ mit der Parallelschaltung des Widerstandes $R_1$ mit dem Kondensator C mit der Klemmenspannung $U_1$ der Batterie zu verbinden bzw. diese Verbindung wieder zu unterbrechen.

Der Mikrocontroller arbeitet wie folgt: Der Mikrocontroller µC bestimmt ständig eine Schaltschwelle von High nach Low, die der zu der Zeit vorhandenen Betriebsspannung der Batterie mit einem Faktor k (k<1) proportional ist.

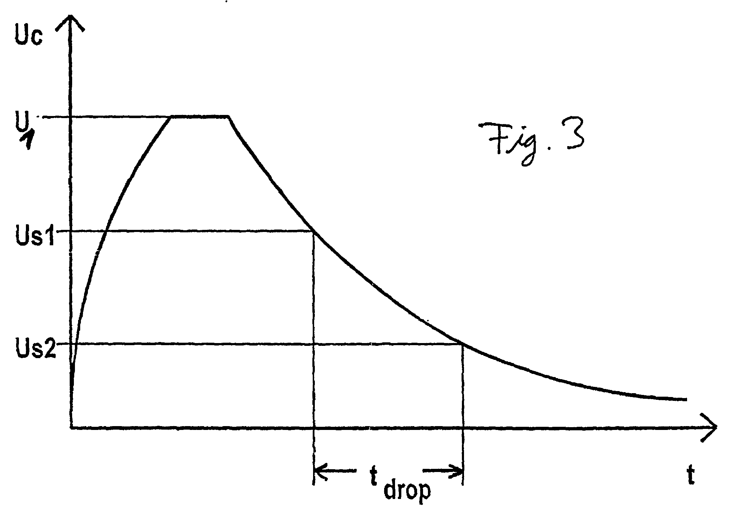

Zunächst wird der Ein-/Ausgang EA des Mikrocontrollers µC als Ausgang geschaltet, wodurch die Reihenschaltung von Widerstand $R_2$ und der Parallelschaltung des Widerstandes $R_1$ mit dem Kondensator C an der Klemmenspannung $U_1$ der Batterie anliegt und der Kondensator C sich, wie in Fig. 3 gezeigt, auflädt.

Sobald die Leerlaufspannung $U_o$ am Kondensator C anliegt (Plateau in Fig. 3), wird der Ein-/Ausgang EA des Mikrocontrollers wieder als Eingang geschaltet. Die Klemmenspannung der Batterie (B) liegt dadurch nicht mehr an der Reihenschaltung an und der Kondensator C entlädt sich über den Widerstand $R_1$. Die Spannung $U_c$ am Kondensator C sinkt also gemäß der in Fig. 3 gezeigten Exponentialfunktion ab.

Erreicht die Spannung am Kondensator C die Schaltschwelle $U_{S1}$ (=k*$U_1$), so wird dies vom Mikrocontroller µ C registriert und im selben Moment der Zusatzlastwiderstand $R_3$ zugeschaltet. Infolge des Spannungseinbruchs an der Batterie sinkt dann auch die Schaltschwelle auf der Kennlinie in Fig. 3 um $\Delta U_S$ auf $U_{S2}$ (=k*$U_1'$), so daß ein zweiter Übergang erfolgen kann.

Die Zeit $t_{drop}$ (siehe Fig. 3) vom ersten bis zum zweiten Übergang wird vom Mikrocontroller µ C gemessen. Für diese Zeit gilt:

$$U_{S2} = U_{S1} * e^{-\frac{t_{drop}}{R_1 * C}} \Rightarrow \ln\left(\frac{U_{S2}}{U_{S1}}\right) = -\frac{t_{drop}}{R_1 * C}$$

$$t_{drop} = -R_1 * C * \ln\left(1 - \frac{\Delta U_S}{U_{S1}}\right) \qquad mit\ \Delta U_S = U_{S1} - U_{S2} \tag{2}$$

Der auftretende Logarithmus kann in eine Reihe entwickelt werden, es gilt:

$$\ln(1+x) = x - \frac{1}{2}x^2 + \frac{1}{3}x^3 - \frac{1}{4}x^4 + ... \qquad für\ -1 < x < 1$$

Vernachlässigt man Glieder höherer Ordnung als eins dieser Reihe, so erhält man unter der Voraussetzung eines verhältnismäßig kleinen Spannungseinbruchs:

$$t_{drop} \approx R_1 * C * \frac{\Delta U_S}{U_{S1}} \tag{3}$$

Laut Annahme sind die Schwellenspannungen jeweils mit einem Faktor k (k<1) proportional zur Betriebsspannung, also folgt:

$$t_{drop} \approx R_1 * C * \frac{U_{S1} - U_{S2}}{U_{S1}} = R_1 * C * \frac{k*U_1 - k*U_2}{k*U_1} = R_1 * C * \frac{\Delta U_1}{U_1} \tag{4}$$

wobei sich der unbekannte Proportionalitätsfaktor k herauskürzt.

Somit wurde das benötigte Verhältnis $\Delta U_1/U_1$ bestimmt.

Insgesamt erhält man mit den Gleichungen (1) und (4) für den Innenwiderstand $R_i$ der Batterie:

$$R_i \approx t_{drop} * \frac{R_3}{R_1 * C} \tag{5}$$

Da die gemessene Zeit $t_{drop}$ im Mikrocontroller als Zählergebnis vorliegt, ist mittels eines im Mikroprozessor vorgegebenen Vergleichers das Erkennen einer schwachen Batterie leicht durchzuführen, wenn der Meßwert $t_{drop}$ mit einem Sollwert (Vorgabewert) verglichen wird.

**Patentansprüche**

1. Vorrichtung zur Bestimmung des Ladezustandes einer Batterie, insbesondere einer Lithiumbatterie für Schlüsselsender oder Fernbedienungen in automotiven Anwendungen, mit Meßmitteln für die Klemmenspannung ($U_1$) und mit Mitteln zur Berechnung des Innenwiderstandes ($R_i$) der Batterie (B) sowie mit weiteren Mitteln zur Feststellung des Ladezustandes der Batterie aus den gemessenen bzw. berechneten Größen ($U_1$, $R_i$), wobei parallel zu der Klemmenspannung ($U_1$) eine mikroprozessorgesteuerte Recheneinheit ($\mu$C) geschaltet ist, an die ein über die Recheneinheit ($\mu$C) auf- bzw. entladbarer Kondensator (C) anschließbar ist, **dadurch gekennzeichnet, daß** ein Ohmscher Widerstand ($R_3$) an die Recheneinheit anschließbar ist, daß der Recheneinheit Meß- und Auswertemittel zur Erfassung einer an dem Kondensator (C) abfallenden Spannung ($U_C$) zugeordnet sind derart, daß in einem ersten Betriebszustand der Recheneinheit ($\mu$C) bei nicht angeschlossenem Widerstand ($R_3$) ein erster, sich aus der im ersten Betriebszustand gültigen Entladezeit des Kondensators. (C) ergebender Zeitpunkt des Erreichens einer ersten Schwellenspannung ($U_{S1}$) registrierbar ist, daß in einem zweiten Betriebszustand der Recheneinheit bei an der Batterie (B) angeschlossenem Widerstand ($R_3$) ein zweiter, sich aus der im zweiten Betriebszustand gültigen Entladezeit des Kondensators (C) ergebender Zeitpunkt des Erreichens einer infolge des Spannungseinbruchs an der Batterie (B) beim Anschließen des Widerstandes ($R_3$) vorhandenen zweiten Schwellenspannung ($U_{S2}$) registrierbar ist wobei beide Schwellenspannungen ($U_{S1}$, $U_{S2}$) jeweils mit einem, kleiner als 1, Faktor k proportional einer zu der Zeit vorhandenen Klemmenspannung sind und daß die zeitliche Differenz ($t_{drop}$) zwischen den Zeitpunkten des Erreichens der beiden Schwellspannungen ($U_{S1}$, $U_{S2}$) auf der Kennlinie der an dem Kondensator (C) abfallenden Spannung ($U_C$) in der Recheneinheit als dem Innenwiderstand ($R_i$) proportionale Meßgröße berechenbar und abspeicherbar ist.

2. Vorrichtung nach Anspruch 1,
**dadurch gekennzeichnet, daß** parallel zum externen Kondensator (C) ein weiterer Widerstand ($R_1$) geschaltet ist.

3. Vorrichtung nach Anspruch 2,
**dadurch gekennzeichnet, daß** zur Begrenzung des Aufladestroms ein zwischen Recheneinheit ($\mu$C) und Kondensator (C) geschalteter Widerstand ($R_2$) vorgesehen ist.

4. Vorrichtung nach Anspruch 1,
**dadurch gekennzeichnet, daß** die Recheneinheit ($\mu$C) eine Vergleichereinheit enthält, in der ein vorgebbarer Sollwert für die zeitliche Differenz zwischen dem Auftreten der beiden Schwellenspannungswerte ($U_{S1}$, $U_{S2}$) abspeicherbar ist, welcher mit dem gemessenen zeitlichen Differenzwert ($t_{drop}$) derart vergleichbar ist, daß, falls der gemessene Wert den Sollwert überschreitet, auf einen unzulässigen Restladezustand schließbar ist.

5. Verfahren zur Bestimmung des Ladezustandes einer Batterie (B), insbesondere einer Lithiumbatterie für Schlüsselsender oder Fernbedienungen in automotiven Anwendungen, bei dem sowohl die Klemmenspannung ($U_1$) der Batterie als auch deren Innenwiderstand ($R_i$) gemessen und zur Ermittlung des Ladezugtandes aus den gemessenen Größen ($U_1$, $R_i$) ein Bezugswert ermittelt wird,
und bei dem zur Bestimmung einer dem Innenwiderstand ($R_i$) proportionalen Meßgröße eine Recheneinheit ($\mu$C) parallel zur Klemmenspannung ($U_1$) geschaltet ist und ein externer Kondensator (C) an die Recheneinheit anschließbar ist, **dadurch gekennzeichnet**, daß ein Ohmschen Widerstand ($R_3$) an die Recheneinheit zuschaltbar ist, daß eine am Kondensator (C) abfallende Spannung derart ausgewertet wird, daß in einem ersten Betriebszustand der Recheneinheit ($\mu$C) bei nicht angeschlossenem Widerstand ($R_3$) ein erster, sich aus der im ersten Betriebszustand gültigen Entladezeit des Kondensators (C) ergebender Zeitpunkt des Erreichens einer ersten Schwellenspannung ($U_{S1}$) registriert wird, und daß in einem zweiten Betriebszustand der Recheneinheit bei an der Batterie (B) angeschlossenem Widerstand ($R_3$) ein zweiter, sich aus der im zweiten Betriebszustand gültigen Entladezeit des Kondensators (C) ergebender Zeitpunkt des Erreichens einer infolge des Spannungseinbruchs an der Batterie (B) beim Anschließen des Widerstands ($R_3$) vorhandenen zweiten Schwellenspannung ($U_{S2}$) registriert wird wobei beide Schwellenspannungen ($U_{S1}$, $U_{S2}$) jeweils mit einem, kleiner als 1, Faktor k proportional einer zu der Zeit vorhandenen Klemmenspannung sind und daß die zeitliche Differenz ($t_{drop}$) zwischen den Zeitpunkten des Erreichens der beiden Schwellenspannungswerte ($U_{S1}$ $U_{S2}$) auf der Kennlinie der am Kondensator (C) abfallenden Spannung ($U_C$) in der Recheneinheit als dem innenwiderstand ($R_i$) proportionale Meßgröße berechenbar und abspeicherbar ist.

6. Verfahren nach Anspruch 1,
**dadurch gekennzeichnet, daß** die Zuschaltung des externen Widerstandes ($R_3$) zeitgleich mit dem Erreichen des ersten Schwellenspannungswertes ($U_{S1}$) erfolgt.

**7.** Verfahren nach Anspruch 5 oder 6,
**dadurch gekennzeichnet, daß** der Mikrocontroller (μC)

1) in einem ersten Schritt an die Parallelschaltung eines weiteren Widerstandes ($R_1$) und eines Kondensators (C) die Klemmenspannung ($U_1$) der zu überwachenden Batterie (B) anlegt, so daß sich der Kondensator (C) auflädt,

2) in einem zweiten Schritt die Parallelschaltung des Widerstandes ($R_1$) und des Kondensators (C) wieder von der Batteriespannung ($U_1$) abschaltet, wodurch sich der Kondensator über ($R_1$) wieder entlädt,

3) in einem dritten Schritt eine Schwellenspannung ($U_{S1}$) entsprechend der am Kondensator (C) anliegenden Spannung ($U_C$) bestimmt,

4) in einem vierten Schritt den Zeitpunkt bestimmt, bei dem die Spannung am Kondensator C die Schwellenspannung ($U_{S1}$) unterschreitet, diesen Zeitpunkt speichert und gleichzeitig zusätzlich einen Referenzwiderstand ($R_3$) an die Batteriespannung ($U_1$) legt,

5) in einem fünften Schritt eine zweite Schwellenspannung ($U_{S2}$), entsprechend der dann am Kondensator (C) anliegenden Spannung ($U_C$) bestimmt,

6) in einem sechsten Schritt den Zeitpunkt bestimmt, bei dem die Spannung am Kondensator (C) die zweite Schwellenspannung ($U_{S2}$) unterschreitet, und

7) in einem siebten Schritt aus der Differenz ($t_{drop}$) des ersten und des zweiten Zeitpunktes, bei dem der erste und der zweite Schwellenwert unterschritten wurden, aus dem Ohmschen Widerstand ($R_3$), dem weiteren Widerstand ($R_1$) und dem Kondensator (C) den Innenwiderstand ($R_i$) der Batterie bestimmt aus dem für einen verhältnismäßig kleinen Schwellenspannungseinbruch $\Delta U_S = U_{S1} - U_{S2}$ gültigem Zusammenhang:

$$R_i = t_{drop} * R_3 / (R_1 * C).$$

**Claims**

**1.** Apparatus for determining the state of charge of a battery, in particular a lithium battery for key transmitters or remote controls in automotive applications, with measuring means for the terminal voltage ($U_1$) and with means for calculating the internal resistance ($R_i$) of the battery (B) as well as with further means for establishing the state of charge of the battery from the measured or calculated quantities ($U_1$, $R_i$), wherein in parallel with the terminal voltage ($U_1$) is connected a microprocessor-controlled computing unit (μC) to which can be connected a capacitance (C) which can be charged and discharged via the computing unit (μC), **characterised in that** an ohmic resistance ($R_3$) can be connected to the computing unit, **in that** associated with the computing unit are measuring and evaluating means for detecting a voltage ($U_C$) falling at the capacitance (C) such that in a first operating state of the computing unit (μC) when the resistance ($R_3$) is not connected there can be recorded a first moment of reaching a first threshold voltage ($U_{S1}$), arising from the discharge time of the capacitance (C) which holds true in the first operating state, **in that** in a second operating state of the computing unit when the resistance ($R_3$) is connected to the battery (B) there can be recorded a second moment of reaching a second threshold voltage ($U_{S2}$), arising from the discharge time of the capacitance (C) which holds true in the second operating state, which second threshold voltage ($U_{S2}$) exists as a result of voltage breakdown at the battery (B) upon connection of the resistance ($R_3$), wherein both threshold voltages ($U_{S1}$, $U_{S2}$) are proportional to a terminal voltage existing at the time, in each case with a factor k of less than 1, and **in that** the time difference ($t_{drop}$) between the moments of reaching the two threshold voltages ($U_{S1}$, $U_{S2}$) on the characteristic curve of the voltage ($U_C$) falling at the capacitance (C) can be calculated and stored in the computing unit as a measured quantity proportional to the internal resistance ($R_i$).

**2.** Apparatus according to claim 1, **characterised in that** in parallel with the external capacitance (C) is connected a further resistance ($R_1$).

**3.** Apparatus according to claim 2, **characterised in that** a resistance ($R_2$) connected between computing unit (μC) and capacitance (C) is provided for limiting the charging current.

**4.** Apparatus according to claim 1, **characterised in that** the computing unit (μC) contains a comparator unit in which can be stored a presettable nominal value for the time difference between occurrence of the two threshold voltage values ($U_{S1}$, $U_{S2}$) which can be compared with the measured time difference value ($t_{drop}$) in such a way that, in the event that the measured value exceeds the nominal value, an inadmissible residual state of charge can be deduced.

5. Method for determining the state of charge of a battery (B), in particular a lithium battery for key transmitters or remote controls in automotive applications, in which both the terminal voltage ($U_1$) of the battery and the internal resistance ($R_i$) thereof are measured and a reference value is determined from the measured quantities ($U_1$, $R_i$) to determine the state of charge, and in which, to define a measured quantity proportional to the internal resistance ($R_i$), a computing unit ($\mu C$) is connected in parallel with the terminal voltage ($U_1$) and an external capacitance (C) can be connected to the computing unit, **characterised in that** an ohmic resistance ($R_3$) can be connected to the computing unit, **in that** a voltage falling at the capacitance (C) is evaluated in such a way that, in a first operating state of the computing unit ($\mu C$) when the resistance ($R_3$) is not connected there is recorded a first moment of reaching a first threshold voltage ($U_{S1}$), arising from the discharge time of the capacitance (C) which holds true in the first operating state, and **in that** in a second operating state of the computing unit when the resistance ($R_3$) is connected to the battery (B) there is recorded a second moment of reaching a second threshold voltage ($U_{S2}$), arising from the discharge time of the capacitance (C) which holds true in the second operating state, which second threshold voltage ($U_{S2}$) exists as a result of voltage breakdown at the battery (B) upon connection of the resistance ($R_3$), wherein both threshold voltages ($U_{S1}$, $U_{S2}$) are proportional to a terminal voltage existing at the time, in each case with a factor k of less than 1, and **in that** the time difference ($t_{drop}$) between the moments of reaching the two threshold voltage values ($U_{S1}$, $U_{S2}$) on the characteristic curve of the voltage ($U_C$) falling at the capacitance (C) can be calculated and stored in the computing unit as a measured quantity proportional to the internal resistance ($R_i$).

6. Method according to claim 1, **characterised in that** connection of the external resistance ($R_3$) takes place simultaneously with reaching the first threshold voltage value ($U_{S1}$).

7. Method according to claim 5 or 6, **characterised in that** the microcontroller ($\mu C$)

1) in a first step applies the terminal voltage ($U_1$) of the battery (B) to be monitored to the parallel connection of a further resistance ($R_1$) and a capacitance (C), so that the capacitance (C) is charged up,
2) in a second step disconnects the parallel connection of the resistance ($R_1$) and capacitance (C) from the battery voltage ($U_1$) again, with the result that the capacitance is discharged via ($R_1$) again,
3) in a third step determines a threshold voltage ($U_{S1}$) according to the voltage ($U_C$) occurring at the capacitance (C),
4) in a fourth step determines the moment at which the voltage at the capacitance C falls below the threshold voltage ($U_{S1}$), stores this moment and at the same time additionally applies a reference resistance ($R_3$) to the battery voltage ($U_1$),
5) in a fifth step determines a second threshold voltage ($U_{S2}$) according to the voltage ($U_C$) then occurring at the capacitance (C),
6) in a sixth step determines the moment at which the voltage at the capacitance (C) falls below the second threshold voltage ($U_{S2}$), and
7) in a seventh step from the difference ($t_{drop}$) between the first and second moments at which values fell below the first and second thresholds, from the ohmic resistance ($R_3$), the further resistance ($R_1$) and the capacitance (C), determines the internal resistance ($R_i$) of the battery, from the relationship which applies to a relatively low threshold voltage breakdown $\Delta U_S = U_{S1} - U_{S2}$:

$$R_i = t_{drop} * R_3 / (R_1 * C).$$

**Revendications**

1. Dispositif de détermination de l'état de charge d'une batterie, notamment d'une batterie au lithium, pour émetteurs de clés de verrouillage à distance ou télécommandes dans les applications automobiles, comprenant des moyens de mesure de la tension aux bornes ($U_1$), des moyens de calcul de la résistance intérieure ($R_i$) de la batterie (B) ainsi que d'autres moyens de détermination de l'état de charge de la batterie depuis les grandeurs mesurées et calculées ($U_1$, $R_i$), par ailleurs une unité de calcul ($\mu C$) contrôlée par microprocesseur, branchée en parallèle à la tension aux bornes ($U_1$) unité à laquelle un condensateur (C) chargeable et déchargeable via l'unité ($\mu C$) est susceptible d'être raccordé, **caractérisé en ce qu'**une résistance ohmique (R3) peut être raccordée à l'unité de calcul, que des moyens de mesure et d'analyse sont affectés à l'unité de calcul, en vue de la détection d'une tension ($U_C$) chutant au condensateur (C), de sorte que dans un premier état de fonctionnement de l'unité de calcul ($\mu C$) avec la résistance ($R_3$) non branchée, on peut enregistrer un premier instant de l'obtention d'une première

tension seuil (U$_{S1}$) découlant du temps de décharge du condensateur (C) valable dans le premier état de fonctionnement, et que dans un deuxième état de fonctionnement de l'unité de calcul avec la résistance (R$_3$) branchée à la batterie (B), on peut enregistrer un deuxième instant de l'obtention d'une deuxième tension seuil (U$_{S2}$) découlant du temps de décharge du condensateur (C) valable pour le deuxième état de fonctionnement, du fait de la chute de tension à la batterie (B) lors du branchement de la résistance (R$_3$), les deux tensions seuil (US1, US2) ayant chacune un facteur k inférieur à 1 et étant proportionnelles à la tension du moment existant aux bornes, et que la différence dans le temps (t$_{drop}$) entre les instants de l'obtention des deux tensions seuil (U$_{s1}$, U$_{s2}$) sur la courbe caractéristique de la tension (U$_c$) chutant au condensateur (C) est susceptible d'être calculée et mémorisée dans l'unité de calcul comme grandeur mesurée proportionnelle à la résistance intérieure (R$_1$)

2. Dispositif selon la revendication 1, **caractérisé en ce qu'**une résistance supplémentaire (R$_1$) est branchée en parallèle au condensateur externe (C).

3. Dispositif selon la revendication 2, **caractérisé en ce qu'**une résistance (R$_2$) est prévue et connectée entre l'unité de calcul (µC) et le condensateur (C), en vue de la limitation du courant de charge.

4. Dispositif selon la revendication 1, **caractérisé en ce que** l'unité de calcul (µC) comprend un circuit-comparateur dans lequel une valeur de consigne affectable de la différence dans le temps intervenant entre les deux valeurs de tension de seuil (U$_{S1}$, U$_{S2}$) est susceptible d'être mémorisée, valeur de consigne pouvant être comparée à la valeur mesurée de la différence dans le temps (t$_{drop}$), de sorte que, si la valeur mesurée est supérieure à la valeur de consigne, il est possible de conclure à un état inadmissible de l'état de charge résiduel de la batterie.

5. Procédé de détermination de l'état de charge d'une batterie (B), notamment d'une batterie au lithium pour émetteurs de clés de verrouillage à distance ou télécommandes dans les applications automobiles, grâce auquel on mesure la tension aux bornes (U$_1$) de la batterie et sa résistance interne (R$_i$) et on détermine une valeur de référence découlant des grandeurs mesurées (U$_1$, R$_i$), en vue de déterminer l'état de charge, grâce auquel par ailleurs en vue de la détermination d'une grandeur mesurée proportionnelle à la résistance interne (R$_i$) une unité de calcul est branchée en parallèle à la tension aux bornes (U$_1$) et un condensateur externe (C) est susceptible d'être branché à l'unité de calcul, **caractérisé en ce qu'**une résistance ohmique (R$_3$) peut être raccordée à l'unité de calcul et qu'une tension chutant au condensateur (C) est analysée de sorte que dans un premier état de fonctionnement de l'unité de calcul (µC) avec 1a résistance (R$_3$) non branchée, on peut enregistrer un premier instant de l'obtention d'une première tension seuil (U$_{S1}$) découlant du temps de décharge du condensateur (C) valable dans le premier état de fonctionnement, et que dans un deuxième état de fonctionnement de l'unité de calcul avec la résistance (R$_3$) branchée à la batterie (B), on peut enregistrer un deuxième instant de l'obtention d'une deuxième tension seuil (U$_{S2}$) découlant du temps de décharge du condensateur (C) valable pour le deuxième état de fonctionnement, du fait de la chute de tension à la batterie (B) lors du branchement de la résistance (R$_3$), les deux tensions seuil (U$_{S1}$, U$_{S2}$) ayant chacune un facteur k inférieur à 1 et étant proportionnelles à la tension du moment existant aux bornes, et que la différence dans le temps (t$_{drop}$) entre les instants de l'obtention des deux tensions seuil (U$_{S1}$, U$_{S2}$) sur la courbe caractéristique de la tension (U$_C$) chutant au condensateur (C) est susceptible d'être calculée et mémorisée dans l'unité de calcul comme grandeur mesurée proportionnelle à la résistance intérieure (R$_1$).

6. Procédé selon la revendication 1, **caractérisé en ce que** la mise en circuit de la résistance externe (R$_3$) a lieu simultanément avec l'obtention de la première valeur de la tension de seuil (U$_{S1}$).

7. Procédé selon l'une quelconque des revendications 5 ou 6, **caractérisé en ce que** le microcontrôleur (µC),

   1) comme premier pas, applique au circuit parallèle d'une résistance (R$_1$) supplémentaire et d'un condensateur (C) la tension aux bornes (U$_1$) de la batterie (B) à surveiller, si bien que le condensateur (c) se charge,
   2) comme deuxième pas, déconnecte à nouveau de la tension de la batterie le circuit parallèle de la résistance (R$_1$) et du condensateur (C), provoquant ainsi à nouveau la décharge du condensateur via (R$_1$),
   3) comme troisième pas, définit une tension seuil (U$_{S1}$) en fonction de la tension appliquée au condensateur (C),
   4) comme quatrième pas, définit l'instant où la tension appliquée au condensateur (C) inférieure à la tension seuil (U$_{S1}$), mémorise cet instant et, simultanément, connecte également une résistance de référence (R$_3$) à la tension de la batterie (U$_1$),
   5) comme cinquième pas, détermine une deuxième tension seuil (U$_{S2}$) en fonction de la tension (U$_c$) alors appliquée au condensateur (C),

6) comme sixième pas, définit l'instant où la tension appliquée au condensateur (C) est inférieure à la deuxième tension seuil ($U_{S2}$), et

7) comme septième pas, définit la résistance interne (R1) de la batterie, à partir de la différence ($t_{drop}$) entre le premier et deuxième instant, où la première et la deuxième valeur seuil étaient dépassées vers le bas, et à partir de la résistance ohmique (R3), la résistance suivante (R1) et le condensateur (C), découlant du contexte valable:

$$R_1 = t_{drop} * R_3 \, / \, (R_1 * C)$$

compte tenu d'un effondrement relativement petit de la tension seuil soit :

$$\Delta U_S = U_{S1} - U_{S2}.$$

EP 0 884 600 B1

Fig.1

Fig. 2

10

Fig. 3